# EUROPEAN PATENT APPLICATION

(11) **EP 4 425 540 A1**
(43) Date of publication of application: **04.09.2024**
(21) Application number: 23215097.9
(22) Date of filing: 07.12.2023
(51) Int. Cl.: H01L 21/8238, H01L 27/092, H01L 29/06, H01L 29/66, H01L 29/775, H01L 29/786

(54) **METAL GATE FABRICATION FOR NANORIBBON-BASED TRANSISTORS**

(30) Priority: 28.02.2023 US 202318175591
(71) Applicant: INTEL Corporation, Santa Clara, CA 95054 (US)
(72) Inventor: XU, Guowei, Portland, OR 97229 (US); CHU, Tao, Portland, OR 97229 (US); HUANG, Chiao-Ti, Portland, OR 97229 (US); CHAO, Robin, Portland, OR 97209 (US); TOWNER, David, Portland, OR 97225 (US); ACTON, Orb, Portland, OR 97229 (US); SAADAT, Omair, Portland, OR 97229 (US); ZHANG, Feng, Hillsboro, OR 97123 (US); CRUM, Dax M., Beaverton, OR 97007 (US); ZHANG, Yang, Rio Rancho, NM 87124 (US); GUHA, Biswajeet, Hillsboro, OR 97124 (US); GOLONZKA, Oleg, Beaverton, OR 97007 (US); MURTHY, Anand S., Portland, OR 97229 (US)
(74) Representative: HGF

(57) **Abstract**

A metal gate fabrication method for nanoribbon-based transistors and associated transistor arrangements, IC structures, and devices are disclosed. An example IC structure fabricated using metal gate fabrication method described herein may include a first stack of N-type nanoribbons, a second stack of P-type nanoribbons, a first gate region enclosing portions of the nanoribbons of the first stack and including an NWF material between adjacent nanoribbons of the first stack, and a second gate region enclosing portions of the nanoribbons of the second stack and including a PWF material between adjacent nanoribbons of the second stack, where the second gate region includes the PWF material at sidewalls of the nanoribbons of the second stack and further includes the NWF material so that the PWF material is between the sidewalls of the nanoribbons of the second stack and the NWF material.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 is a flow diagram of an example method of fabricating an IC structure with nanoribbon-based transistors using metal gate fabrication, in accordance with some embodiments.
FIGS. 3-16 provide cross-sectional side views at various stages in the fabrication of an example IC structure according to the method of FIG. 2, in accordance with some embodiments.
FIG. 17 is a top view of a wafer and dies that may include any of the IC structures disclosed herein, in accordance with any of the embodiments disclosed herein.
FIG. 18 is a side, cross-sectional view of an IC device that may include any of the IC structures disclosed herein, in accordance with any of the embodiments disclosed herein.
FIG. 19 is a side, cross-sectional view of an IC package that may include any of the IC structures disclosed herein, in accordance with various embodiments.
FIG. 20 is a side, cross-sectional view of an IC device assembly that may include any of the IC structures disclosed herein, in accordance with any of the embodiments disclosed herein.
FIG. 21 is a block diagram of an example electrical device that may include any of the IC structures disclosed herein, in accordance with any of the embodiments disclosed herein.

### Detailed Description

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating metal gate fabrication for nanoribbon-based transistors, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surfaces. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer; also referred to herein as, simply, "support") over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

Typically, nanoribbon-based transistor arrangements include stacks of nanoribbons, where each stack includes two or more nanoribbons stacked above one another, with a single gate stack that includes a gate electrode material (which may include a work function material) provided for an entire stack or multiple stacks. Optionally, the gate stack may also include a gate dielectric material around each nanoribbon. Such nanoribbon-based transistor arrangements may be fabricated by, first, providing a stack of alternating layers of first and second semiconductor materials over a support (e.g., a substrate, a die, a wafer, or a chip). The first semiconductor material is a material that will later form nanoribbons, while the second semiconductor material is a material that is etch-selective with respect to the first semiconductor material so that it may later be removed to separate different nanoribbons of a stack from one another. For example, the first semiconductor material may be silicon, while the second semiconductor material may be silicon germanium. In such a fabrication process, the first semiconductor material provides the bottom layer of the stack as well two or more layers above the bottom layer, alternating with layers of the second semiconductor material. A stack of first and second semiconductor materials alternating with one another is sometimes referred to as a "superlattice". The fabrication process further includes patterning the superlattice, as well as, possibly, an upper portion of the support into a fin to define the width of future nanoribbons. The fabrication process further includes patterning the superlattice, as well as, possibly, an upper portion of the support into a fin to define the width of future nanoribbons. Sidewalls of a bottom portion of the fin are enclosed by an insulator material commonly referred to as a "shallow trench insulator" (STI) and such a bottom portion of the fin enclosed by the STI is commonly referred to as a "subfin," similar to a subfin portion of fin-based transistors. The subfin may include the bottom layer of the first semiconductor material of the superlattice and an upper portion of the support over which the superlattice was provided. The fabrication process further includes removing the second semiconductor material from the fin to release nanoribbons formed by the fin portions of the first semiconductor material above the subfin. After the nanoribbons are released, a gate stack is provided around portions of the nanoribbons formed of the higher levels of the first semiconductor material, while the first semiconductor material in the subfin portion of the fin may remain but does not serve as a part of the nanoribbon-based transistors.

Performance of nanoribbon-based transistors may depend on a number of factors. Threshold voltage, commonly abbreviated as Vth, refers to the minimum gate-to-source voltage that is needed to create a conducting path between source and drain terminals of a transistor. "Threshold voltage tuning" refers to adapting the threshold voltage of a transistor to a desired value. Some approaches to threshold voltage tuning include using various types of work function materials as portions of gate electrodes of transistors. Some materials are suitable for use in N-type metal-oxide-semiconductor (NMOS) transistors and are, therefore, referred to as "N-type work function (NWF) materials." Other materials are suitable for use in P-type metal-oxide-semiconductor (PMOS) transistors and are, therefore, referred to as "P-type work function (PWF) materials." Work function of a material can be defined as the minimum thermodynamic work (i.e., energy) required to extract one electron from the material. Thus, work function is measured in electron volts (eV) or Joules (J). Work function is one of the fundamental electronic properties of metals, depending on both the bulk composition and surface condition. In context of transistors, NWF materials are generally metals that have a work function that is smaller than the conduction band of the channel material (i.e., the semiconductor material of the channel region of a transistor) or metals that have a work function that is close to (e.g., within +/- 20% of or within +/- 10% of) the conduction band of the channel material, while PWF materials are generally metals that have a work function that is larger than the valence band of the channel material of a transistor or metals that have a work function that is close to (e.g., within +/- 20% of or within +/- 10% of) the valence band of the channel material. Examples of NWF materials are metals and alloys based on titanium and aluminum, such as metals and alloys that include titanium, aluminum, and carbon (e.g., TiAIC), metals and alloys based on metal carbides (e.g., TiC), metals and alloys that include cobalt, etc. Examples of PWF materials are metals and alloys based on metal nitrides (e.g., TiN, MoN, or WN), and tungsten.

Threshold voltage tuning in nanoribbon-based transistors is not trivial. In particular, as is common in the field of CMOS manufacturing, both NMOS and PMOS transistors need to be implemented on the same support (e.g., a substrate or a die). Conventional approaches to providing work function materials in gate stacks of NMOS and PMOS nanoribbon-based transistors include what may be referred to as an "NMOS-first" approach due to the fact that gate patterning starts with patterning stacks of nanoribbons that form basis for future NMOS transistors (such nanoribbons and stacks referred to in the following as, respectively, "NMOS nanoribbons" and "NMOS stacks"), while masking stacks of nanoribbons that form basis for future PMOS transistors (such nanoribbons and stacks referred to in the following as, respectively, "PMOS nanoribbons" and "PMOS stacks"). A typical NMOS-first approach includes defining base NMOS and PMOS work function by providing both a PWF material and a NWF material in a gate region between the nanoribbons of an NMOS stack and providing only a PWF material but not the NWF material in a gate region (e.g., a gate trench) between the nanoribbons of a PMOS stack. A gate fill material such as tungsten is subsequently deposited to fill remaining space in the gate regions.

Such an approach may be practical in some settings but may also present challenges in terms of work function material uniformity and metal gate strain. The challenge of work function material uniformity may be caused by the need to have thin layers of NWF and PWF materials in NMOS stacks and the need for patterning of the NWF material. The patterning process may oxidize the NWF material and cause nonuniformity of the NWF material (exacerbated by the need to have thin layers of NWF and PWF materials), affecting device performance. The challenge of metal gate strain may be caused by the fact that NMOS-first approach includes depositing both a PWF and a NWF material in NMOS stacks but only a PWF material in PMOS stacks. Different gate electrode materials apply different strains, and inventors of the present disclosure realized that performance of NMOS nanoribbons is improved when strain due to a material such as tungsten is applied, while performance of PMOS nanoribbons is improved when strain due to a material that is not tungsten is applied. Because the NMOS-first approach includes depositing both a PWF and a NWF material in NMOS stacks, gate regions of NMOS stacks have relatively little space remaining for filling with a material like tungsten. On the other hand, because only a PWF material is deposited in PMOS stacks, gate regions of PMOS stacks have more space available for filling with a material like tungsten. This is the opposite of what may be desirable for optimizing performance of NMOS and PMOS nanoribbons based on metal gate strain (i.e., it would be desirable to have more of a material like tungsten in NMOS stacks and less of a material like tungsten in PMOS stacks), making the NMOS-first approach suboptimal. These and other challenges associated with the NMOS-first approach may, in turn, lead to the necessity to use multiple work function materials to achieve the desired threshold voltage, complicated lithography steps, and stringent requirements with respect to accurate control of work function material deposition across a wafer.

Fabrication method for nanoribbon-based transistors and associated transistor arrangements, IC structures, and devices that may improve on one or more challenges described above are disclosed. The metal gate fabrication method proposed herein is based on what may be referred to as a "PMOS-first" approach due to the fact that gate patterning starts with patterning stacks of PMOS nanoribbons, while masking stacks of NMOS nanoribbons. Such a fabrication method may allow increasing uniformity of work function materials in gate regions of nanoribbon-based transistors and/or ensure appropriate metal gate strains applied to NMOS and PMOS nanoribbons, which may, in turn, reduce or eliminate undesirable threshold voltage shifts and provide greater threshold voltage control and uniformity in nanoribbon-based transistors. The PMOS-first metal gate fabrication method may result in several features characteristic of the method in the final IC structure. For example, in one aspect, an example IC structure fabricated using PMOS-first metal gate fabrication may include a first stack of N-type nanoribbons (i.e., portions of the nanoribbons of the first stack are channel regions of N-type transistors), a second stack of P-type nanoribbons (i.e., portions of the nanoribbons of the second stack are channel regions of P-type transistors), a first gate region enclosing portions of the nanoribbons of the first stack and including an NWF material between adjacent nanoribbons of the first stack, and a second gate region enclosing portions of the nanoribbons of the second stack and including a PWF material between adjacent nanoribbons of the second stack, where the second gate region includes the PWF material at sidewalls of the nanoribbons of the second stack and further includes the NWF material so that the PWF material is between the sidewalls of the nanoribbons of the second stack and the NWF material. In such an IC structure, in the first gate region, the PWF material may be absent between the adjacent nanoribbons of the first stack.

IC structures as described herein, in particular IC structures with nanoribbon-based transistors formed using PMOS-first metal gate fabrication, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

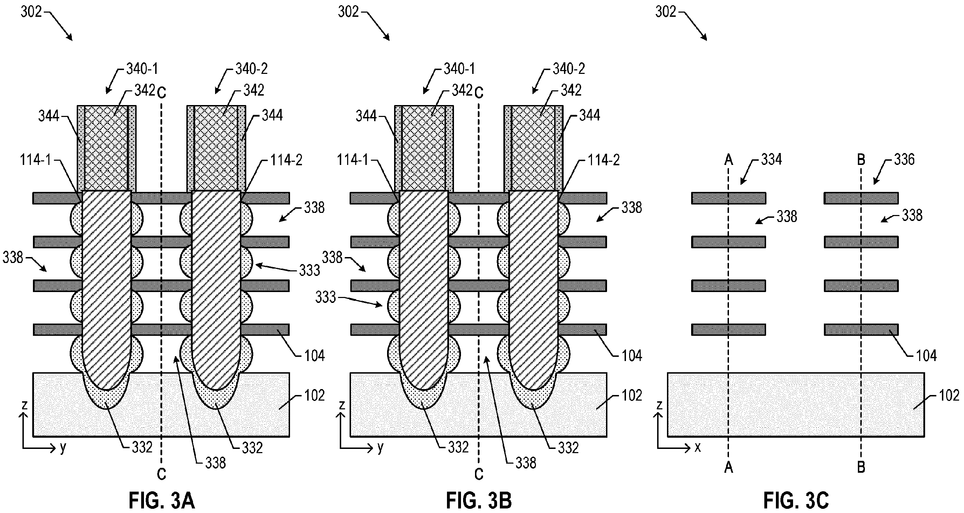

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 3A-3C, such a collection may be referred to herein without the letters, e.g., as "FIG. 3."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of nanoribbon-based transistors formed using PMOS-first metal gate fabrication as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials. Materials referred to herein with formulas cover all materials that include elements of the formula, e.g., TiC refers to any material that includes titanium and carbon, WN refers to any material that includes tungsten and nitrogen, etc.

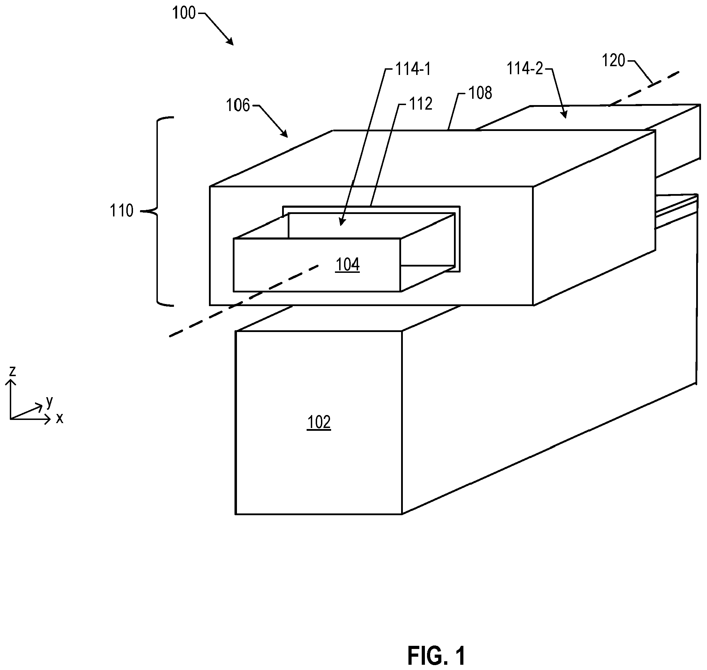

FIG. 1 provides a perspective view of an example IC structure 100 with a nanoribbon-based transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

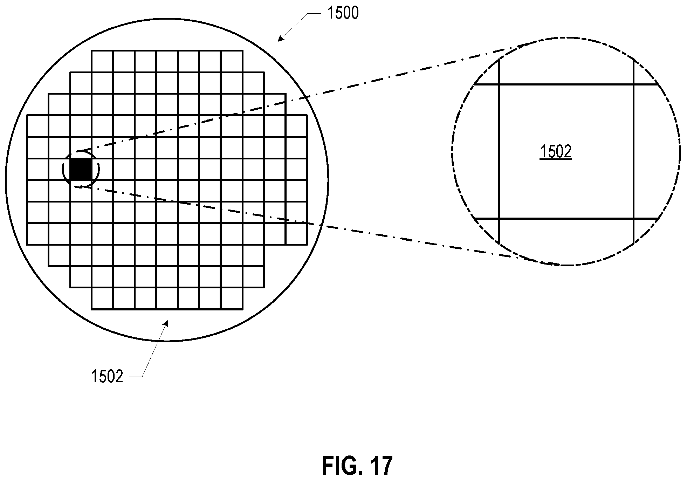

Implementations of the present disclosure may be formed or carried out on any suitable support 102, such as a substrate, a die, a wafer, or a chip. The support 102 may, e.g., be the wafer 1500 of FIG. 17, discussed below, and may be, or be included in, a die, e.g., the singulated die 1502 of FIG. 17, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure with nanoribbon-based transistors formed using PMOS-first metal gate fabrication as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another, e.g., as is shown in FIGS. 3-16 showing IC structures that may be examples of the IC structure 100. In some embodiments, a portion of the support 102 right below the lowest nanoribbon 104 of the stack may be shaped as a subfin extending away from a base, as is known in the field of nanoribbon-based transistors.

The nanoribbon 104 may take the form of a nanowire or nanoribbon, for example. In some embodiments, an area of a transversal cross-section of the nanoribbon 104 (i.e., an area in the x-z plane of the example coordinate system x-y-z shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the y-axis of the example coordinate system shown in FIG. 1) may be at least about 3 times larger than a height of the nanoribbon 104 (i.e., a dimension measured in a plane perpendicular to the support 102, e.g., along the z-axis of the example coordinate system shown in FIG. 1), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an NMOS transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a PMOS transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back end fabrication to avoid damaging other components, e.g., front end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include at least one PWF material or NWF material as described in greater detail below with respect to the PMOS-first metal gate fabrication method, depending on whether the transistor 110 is a PMOS transistor or an NMOS transistor (PWF metal used as the gate electrode material 108 when the transistor 110 is a PMOS transistor and NWF metal used as the gate electrode material 108 when the transistor 110 is an NMOS transistor). For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of two or more metal layers, where one or more metal layers are work function metal layers and at least one metal layer is a fill metal layer such as any of the gate fill materials described above (e.g., W). Further layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabricate of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and source/drain contacts of the transistor 110 and could be made of a low-k dielectric material, some examples of which have been provided above. A gate spacer may include pores or air gaps to further reduce its dielectric constant.

In some embodiments, e.g., when the transistor 110 is a storage transistor of a hysteretic memory cell (i.e., a type of memory that functions based on the phenomenon of hysteresis), the gate insulator 112 may be replaced with, or complemented by, a hysteretic material. In some embodiments, a hysteretic material may be provided as a layer of a ferroelectric (FE) or an antiferroelectric (AFE) material. Such an FE/AFE material may include one or more materials that can exhibit sufficient FE/AFE behavior even at thin dimensions, e.g., such as an insulator material at least about 10% of which is in an orthorhombic phase or a tetragonal phase (e.g., as a material in which at most about 90% of the material may be amorphous or in a monoclinic phase). Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germanium-doped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used to replace, or to complement, the gate insulator 112, and are within the scope of the present disclosure. The FE/AFE material included in the gate stack 106 may have a thickness that may, in some embodiments, be between about 0.5 nanometers and 10 nanometers, including all values and ranges therein (e.g., between about 1 and 8 nanometers, or between about 0.5 and 5 nanometers). In other embodiments, a hysteretic material may be provided as a stack of materials that, together, exhibit hysteretic behavior. Such a stack may include, e.g., a stack of silicon oxide and silicon nitride. Unless specified otherwise, descriptions provided herein with respect to the gate insulator 112 are equally application to embodiments where the gate insulator 112 is replaced with, or complemented by, a hysteretic material.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D electrodes (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even with doped to realize threshold voltage tuning as described herein, the channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D electrode (which may also be referred to as a "first S/D contact") coupled to a first S/D region 114-1 of the transistor 110 and the gate stack 106 as well as between a second S/D electrode (which may also be referred to as a "second S/D contact") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

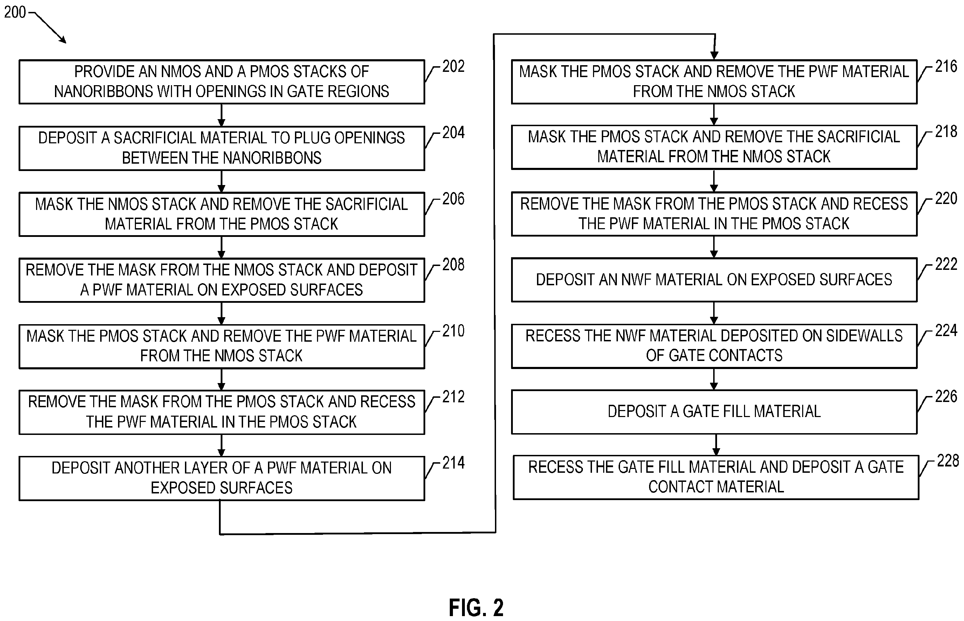

FIG. 2 is a flow diagram of an example method 200 of fabricating an IC structure with nanoribbon-based transistors using PMOS-first metal gate fabrication, in accordance with some embodiments. Although the operations of the method 200 are illustrated once each and in a particular order, the operations may be performed in any suitable order and repeated as desired. For example, one or more operations may be performed in parallel to fabricate multiple IC structures with nanoribbon-based transistors substantially simultaneously. In another example, the operations may be performed in a different order to reflect the structure of an IC device in which nanoribbon-based transistors formed using PMOS-first metal gate fabrication will be implemented.

In addition, the example fabricating method 200 may include other operations not specifically shown in FIG. 2, such as various cleaning or planarization operations as known in the art. For example, in some embodiments, the support 102, as well as layers of various other materials subsequently deposited thereon, may be cleaned prior to, after, or during any of the processes of the method 200 described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method 200 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

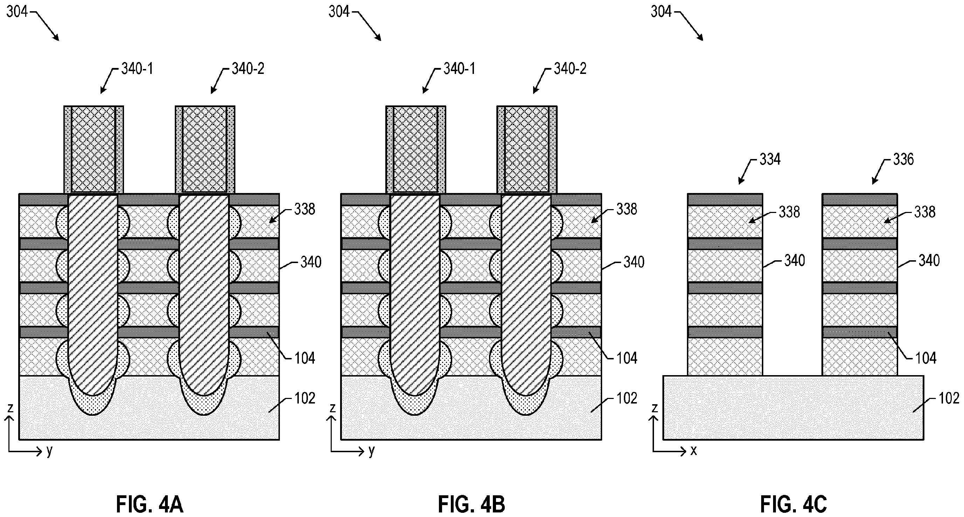

FIGS. 3-16 provide cross-sectional side views at various stages in the fabrication of an example IC structure with nanoribbon-based transistors formed using PMOS-first metal gate fabrication according to the method 200 of FIG. 2, in accordance with some embodiments. Each of FIGS. 3-16 includes three figures, labeled with letters A, B, and C (e.g., FIG. 3 includes FIGS. 3A, 3B, and 3C), providing different cross-sectional side views of a given IC structure. In particular, those figures of FIGS. 3-16 that are labeled with a letter A (e.g., FIG. 3A, FIG. 4A, and so on) illustrate cross-sections in the y-z plane of the example coordinate system shown in FIG. 1 along a plane AA shown in FIG. 3C. Those figures of FIGS. 3-16 that are labeled with a letter B (e.g., FIG. 3B, FIG. 4B, and so on) illustrate cross-sections in the y-z plane of the example coordinate system shown in FIG. 1 along a plane BB shown in FIG. 3C. Those figures of FIGS. 3-16 that are labeled with a letter C (e.g., FIG. 3C, FIG. 4C, and so on) illustrate cross-sections in the x-z plane of the example coordinate system shown in FIG. 1 along a plane CC shown in FIG. 3A and FIG. 3B. In order to not clutter the drawings, planes AA, BB, and CC are only shown in FIG. 3.

The method 200 may begin with a process 202 that includes providing an NMOS stack and a PMOS stack of released nanoribbons over a support. An IC structure 302 of FIG. 3 illustrates an example result of the process 202. The IC structure 302 includes a support 102 with an NMOS stack 334 and a PMOS stack 336 provided over the support 102. Each of the stacks 334, 336 includes a plurality of nanoribbons 104 stacked above one another. FIG. 3 and subsequent drawings illustrate four nanoribbons 104 in each of the stacks 334, 336, but, in other embodiments, the stacks 334, 336 may include any other number of two or more nanoribbons 104. As described above, the material composition of the nanoribbons 104 may be different depending on whether the nanoribbons 104 are to implement NMOS or PMOS transistors. Thus, the material composition of the nanoribbons 104 in the NMOS stack 334 may be different from the material composition of the nanoribbons 104 in the PMOS stack 336. The nanoribbons 104 are "released" in that openings 338 are formed around channel portions of the nanoribbons 104, i.e., the openings 338 are where gate electrode materials such as the gate electrode material 108, described above, are to be provided. Although not specifically shown in FIGS. 3-16, the walls of openings 338 may be lined with a liner of a gate insulator such as any of the gate insulators 112, described above.

FIGS. 3A and 3B further illustrate source and drain regions and contacts for the NMOS stack 334 and the PMOS stack 336. In particular, FIG. 3A illustrates a S/D region 114-1 and a S/D region 114-2 of the NMOS stack 334, while FIG. 3B illustrates a S/D region 114-1 and a S/D region 114-2 of the PMOS stack 336. FIGS. 3A and 3B illustrate an insulator material 332 that electrically isolates the S/D regions 114 from the material of the support 102, as well as from the conductive materials that will later be present within the openings 338. Portions of the insulator material 332 extending from the respective side of the S/D regions 114 into the openings 338 may be referred to as "dimples" 333. In other embodiments, shape of the dimples 333 may be different from that shown in FIGS. 3A and 3B, as long as the dimples 333 of the insulator material 332 provide electrical isolation between the S/D regions 114 and conductive materials that will later be deposited in the openings 338. The insulator material 332 may include any suitable insulator material, e.g., one or more materials described with reference to the ILD materials.

FIGS. 3A and 3B further illustrate two S/D contacts 340, where a first S/D contact 340-1 may be an electrical contact to the S/D region 114-1 and a second S/D contact 340-2 may be an electrical contact to the S/D region 114-2. Each of the S/D contacts 340 may include a contact fill material 342, and one or more liners 344 (shown in FIGS. 3A and 3B and subsequent drawings as a single liner 344). The contact fill material 342 may be in electrical contact with the respective S/D regions 114, and may include any suitable electrically conductive materials such as copper. The one or more liners 344 may include one or more of spacer materials, diffusion barrier materials, adhesion materials, etc., as known in the art for forming contacts to various components of IC structures.

In order to not clutter subsequent drawings of FIGS. 3-16 past FIG. 3, the S/D regions 114, the S/D contacts 340, the insulator material 332, the dimples 333, the contact fill material 342, and the liners 344 are not individually labeled in these drawings, even though they are shown exactly they appear in FIGS. 3A and 3B. Also for the purpose of not cluttering the subsequent drawings, not all of the openings 338 labeled in FIG. 3 are labeled in the subsequent drawings.

The method 200 may then continue with a process 204 that includes depositing a sacrificial material that can plug the openings 338 between the nanoribbons 104 and may subsequently be successfully removed without compromising the surrounding materials. An IC structure 304 of FIG. 3 illustrates an example result of the process 204. As shown in FIG. 4, the IC structure 304 includes a sacrificial material 340 within the openings 338. The sacrificial material 340 may be any suitable material that is etch-selective with respect to the semiconductor material of the nanoribbons 104 so that, in a later process, the sacrificial material 340 may be etched away without substantially etching materials that are in contact with the openings 338, e.g., the semiconductor material of the nanoribbons 104 and the insulator material 332. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the sacrificial material 340 may include aluminum and oxygen (e.g., the sacrificial material 340 may be aluminum oxide). Examples of deposition techniques that may be used in the process 204 to provide the sacrificial material 340 in the openings 338 may include atomic layer deposition (ALD), chemical vapor deposition (CVD), plasma enhanced CVD (PECVD), or/and physical vapor deposition (PVD) processes such as sputter. Careful control of the deposition conditions may allow ensuring that all of the openings 338 are fully filled with the sacrificial material 340 as shown in FIG. 3, although, in some embodiments, the openings 338 may be only partially filled with the sacrificial material 340.

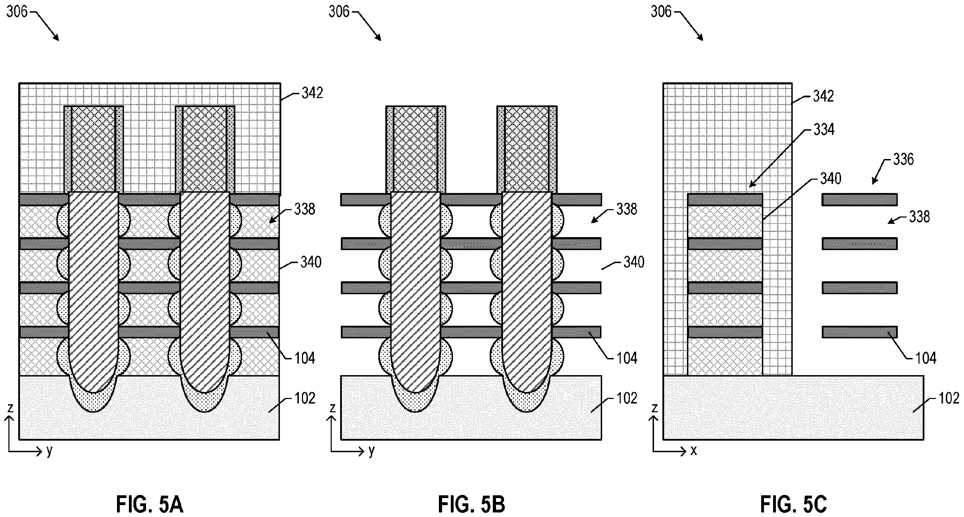

The method 200 may further include a process 206, in which the NMOS portion of the IC structure is covered with a mask and the sacrificial material deposited in the process 204 is removed from the PMOS portion. An IC structure 306 of FIG. 5 illustrates an example result of the process 206. As shown in FIG. 5, the IC structure 306 includes a mask 342 covering the NMOS stack 334, leaving the PMOS stack 336 exposed, which allows removing the sacrificial material 340 from the openings 338 between the nanoribbons 104 of the PMOS stack 336. Because the PMOS stack 336 is being processed before the NMOS stack 334 is processed (in terms of metal gate patterning), the method 200 is a PMOS-first method. Any suitable patterning technique may be used in the process 206 to provide the mask 342 with an opening exposing the PMOS stack 336, such as, but not limited to, photolithographic or electron-beam (e-beam) patterning, possibly in conjunction with a suitable etching technique, e.g., a dry etch, such as e.g., radio frequency (RF) reactive ion etch (RIE) or inductively coupled plasma (ICP) RIE. The same applies for other masks used in the method 200. Furthermore, any of these etching techniques may also be used in the process 206 to etch the sacrificial material 340 in the portions of the IC structure that are exposed by the mask 342, thus etching the sacrificial material 340 in the openings 338 between the nanoribbons 104 of the PMOS stack 336. In some embodiments, the etch performed in the process 206 may include an anisotropic etch, using etchants in a form of e.g., chemically active ionized gas (i.e., plasma) using e.g., bromine (Br) and chloride (Cl) based chemistries. In some embodiments, during the etch of the process 206, the IC structure may be heated to elevated temperatures, e.g., to temperatures between about room temperature and 200 degrees Celsius, including all values and ranges therein, to promote that byproducts of the etch are made sufficiently volatile to be removed from the surface.

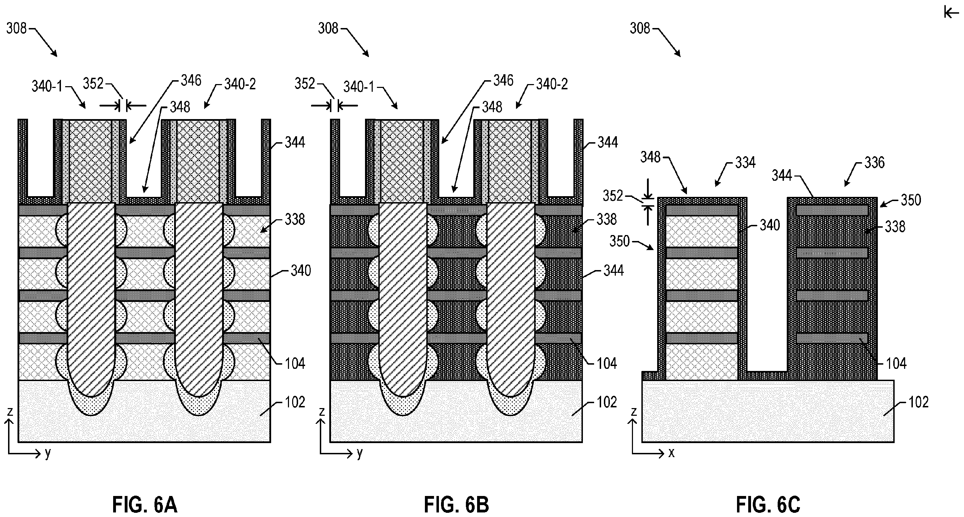

In a process 208 of the method 200, the mask deposited in the process 206 may be removed and a layer of a PWF material may be deposited on all exposed surfaces. An IC structure 308 of FIG. 6 illustrates an example result of the process 208. As shown in FIG. 6, the mask 342 that was previously covering the NMOS stack 334 is removed, leaving both the NMOS stack 334 and the PMOS stack 336 exposed, and a PWF material 344 is deposited on all exposed surfaces. Because the sacrificial material 340 was removed from the openings 338 between the nanoribbons 104 of the PMOS stack 336 in the process 206, the PWF material 344 may be deposited into those areas. In some embodiments, the PWF material 344 deposited in the process 208 may completely fill the openings 338 as shown in FIG. 6 and the subsequent drawings; however, in other embodiments, multiple rounds of deposition of the PWF material 344 mat be needed to completely fill the openings 338 or at least pinch off the openings 338 so that later no other material may be deposited in them in addition to the PWF material 344. An example of such an additional round of deposition of the PWF material 344 is a process 214, described below. Because the sacrificial material 340 remains in between the nanoribbons 104 of the NMOS stack 334, no PWF material 344 is deposited there. FIGS. 6A and 6B specifically label a portion 346 of the PWF material 344 that is on sidewalls of the openings between adjacent S/D contacts 340. FIGS. 6A and 6B, as well as FIG. 6C, further specifically label a portion 348 of the PWF material 344 on top of the gate regions of the NMOS stack 334 and the PMOS stack 336 (i.e., the portion 348 is a portion of the PWF material 344 on top of the uppermost nanoribbons 104 of the stacks, substantially parallel to the support 102). FIG. 6C also specifically labels a portion 350 of the PWF material 344 on sidewalls of the gate regions of the NMOS stack 334 and the PMOS stack 336 (i.e., the portion 350 is a portion of the PWF material 344 that extends away from the support 102). The portions 346, 348, and 350 may be materially continuous portions of the PWF material 344, as depicted in FIG. 6. In some embodiments, a thickness 352 of each of the portions 346, 348, and 350 may be between about 0.5 nanometer and 20 nanometers, e.g., between about 0.5 and 10 nanometers, or between about 1 and 5 nanometers. Examples of deposition techniques that may be used in the process 208 to deposit the PWF material 344 may include ALD or CVD, and the PWF material 344 may include any of the PWF materials described above, e.g., TiN. The PWF material 344 may include any suitable PWF material that is etch-selective with respect to a mask used to mask the PMOS portion of the IC structure in a subsequent process (e.g., the mask 354 of process 210), and may be etch-selective with respect to the material of the nanoribbons 104 as to not damage the nanoribbons 104 when the PWF material 344 is later removed from the NMOS portion.

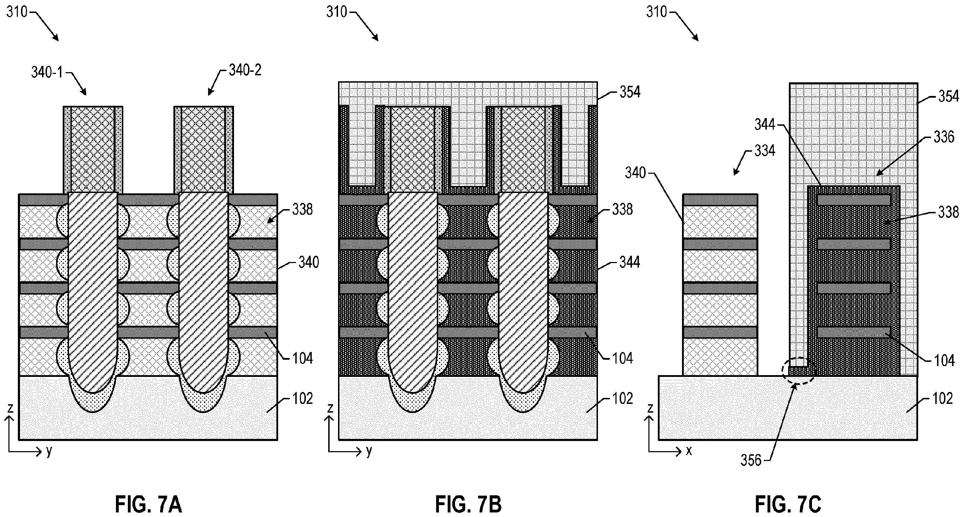

The method 200 may further include a process 210, in which the PMOS portion of the IC structure is covered with a mask and the PWF material deposited in the process 208 is removed from the exposed NMOS portion. An IC structure 310 of FIG. 7 illustrates an example result of the process 210. As shown in FIG. 7, the IC structure 310 includes a mask 354 covering the PMOS stack 336, leaving the NMOS stack 334 exposed, which allows removing the PWF material 344 from the gate regions of the NMOS stack 334. This means that the portion 346 of the PWF material 344 is removed from the sidewalls of the openings between adjacent S/D contacts 340 of the NMOS stack 334, as shown in FIG. 7A. This also means that the portions 348 and 350 of the PWF material 344 are removed from the top and the sidewalls of the gate region of the NMOS stack 334, as shown in FIG. 7C. FIG. 7C further illustrates that, because of the alignment of the mask 354 with respect to the PMOS stack 336, a portion 356 of the PWF material 344 (shown in FIG. 7C in an area enclosed by a dashed contour) may remain at the bottom of all of the remaining PWF material 344, extending away from the PWF material 344 between the nanoribbons 104 of the PMOS stack 336. Any suitable process may be used in the process 210 to remove the PWF material 344 without substantially affecting the sacrificial material 340 in between the nanoribbons 104 of the NMOS stack 334, and without substantially affecting the nanoribbons 104 themselves in the NMOS stack 334. For example, any suitable etching techniques, e.g., a wet etch, may be used.

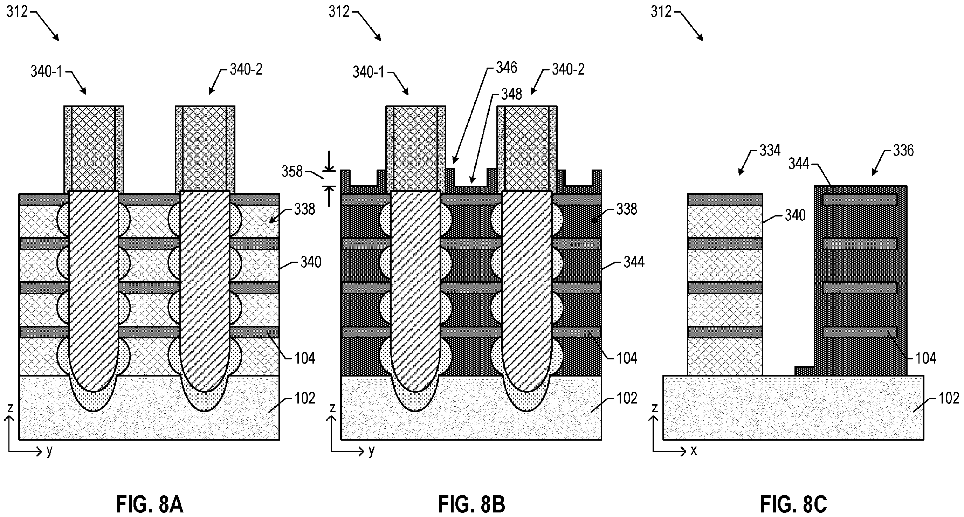

The method 200 may then proceed with a process 212, in which the mask deposited over the PMOS portion of the IC structure is removed and the portions 346 of the PWF material deposited in the process 208 are recessed in the exposed PMOS portion. An IC structure 312 of FIG. 8 illustrates an example result of the process 212. As shown in FIG. 8B, the portions 346 on sidewalls of adjacent S/D contacts 340 are recessed. In some embodiments, a height 358 of the portions 346 above the PMOS stack 336 may be between about 2 nanometer and 20 nanometers, e.g., between about 3 and 20 nanometers, or between about 3 and 15 nanometers. In some embodiments, the portions 346 may be removed completely, leaving only the portions 348 on top of uppermost the nanoribbon 104 of the PMOS stack 336. Any suitable process may be used in the process 212 to recess the portions 346 of the PWF material 344 in the PMOS stack 336, such as any suitable selective etch techniques.

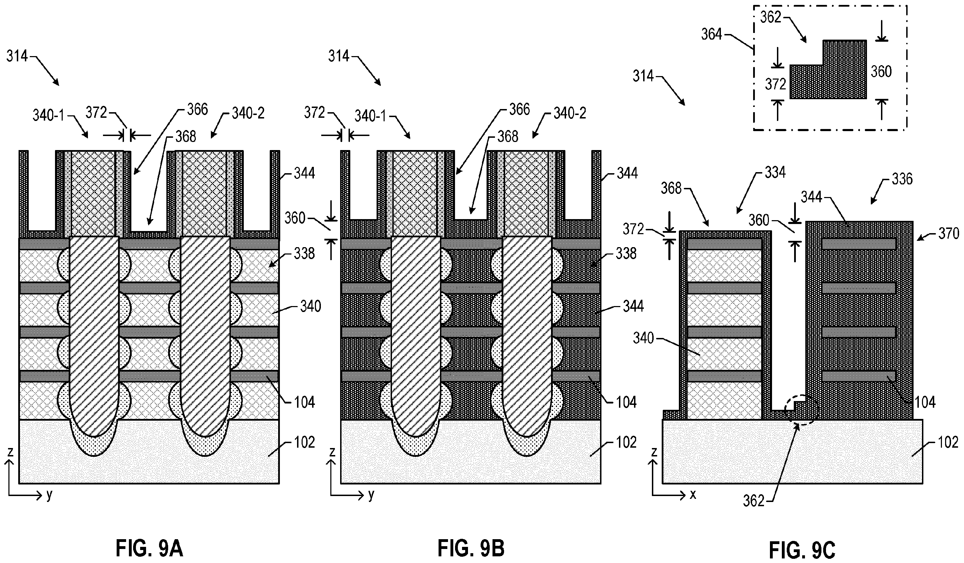

In some embodiments, a single round of deposition of the PWF material performed in the process 208 of the method 200 may not be sufficient to pinch off or completely fill the openings 338 of the PMOS stack 336. In such embodiments, the method 200 may proceed with a process 214, in which another round of depositing a PWF material on all exposed surfaces may be performed, similar to the deposition of the process 208. An IC structure 314 of FIG. 9 illustrates an example result of the process 214. As shown in FIG. 9, both the NMOS stack 334 and the PMOS stack 336 were exposed at the end of the process 212, which allows depositing the PWF material 344 on all exposed surfaces of both stacks. In some embodiments, material compositions of the PWF material 344 deposited in processes 208 and 214 may be the same, while, in other embodiments, material compositions of the PWF material 344 deposited in processes 208 and 214 may be different. As is with the process 208, because the sacrificial material 340 remains in between the nanoribbons 104 of the NMOS stack 334, no PWF material 344 is deposited there in the process 214. Similar to the process 208, the process 214 results in depositing a portion 366 of the PWF material 344 on sidewalls of the openings between adjacent S/D contacts 340 of the PMOS stack 336 (similar to the portion 346 of the process 208), a portion 368 of the PWF material 344 on top of the gate regions of the NMOS stack 334 and the PMOS stack 336 (similar to the portion 348 of the process 208), and a portion 370 of the PWF material 344 on sidewalls of the gate regions of the NMOS stack 334 and the PMOS stack 336 (similar to the portion 350 of the process 208). However, because the portion 346 of the PWF material 344 of the previous deposition round was recessed, while the portions 368 were remaining in the PMOS stack 336, a thickness of the PWF material 344 at the bottom of openings between adjacent S/D contacts 340 of the PMOS stack 336 is greater than a thickness of the PWF material 344 at the bottom of openings between adjacent S/D contacts 340 of the NMOS stack 334. The latter is a thickness 372 labeled in each of FIGS. 9A-9C, which may be similar to the thickness 352. The former is a thickness 360 labeled in FIGS. 9B and 9C, which is a total of the thickness of the one or more layers of the PWF material 344 deposited in the previous rounds (e.g., in the process 208) and the thickness 372 of the PWF material 344 deposited in the current round (i.e., in the process 214).

Because of the second round of deposition of the PWF material 344 over the portion 356 of the PWF material 344 that was remaining at the bottom because of the mask 354 that was used in the process 210, a characteristic step profile may be present in a portion 362 if the PWF material 344 near the bottom of the PMOS stack 336 (shown in FIG. 9C in an area enclosed by a dashed contour). An enlarged version of the portion 362 is shown in an inset 364 of FIG. 9C, illustrating that the step profile may include a layer of the PWF material 344 with the thickness 372 (i.e., the PWF material 344 deposited in the process 214), and layer of the PWF material 344 with the thickness 360 (i.e., the PWF material 344 deposited all deposition rounds of the method 200).

Although not specifically shown in FIG. 2, the method 200 may include additional rounds of removing the PWF material 344 deposited over the NMOS stack 334, recessing the PWF material 344 remaining over the PMOS stack 336, and depositing another round of the PWF material 344. In other words, after the process 214, a sequence of the processes 210, 212, and 214 may be repeated one or more times until openings 338 between the nanoribbons 104 of the PMOS stack 336 are completely filled in with the PWF material 344 or at least pinched off so that no other material, in particular, no NWF material, may be deposited there.

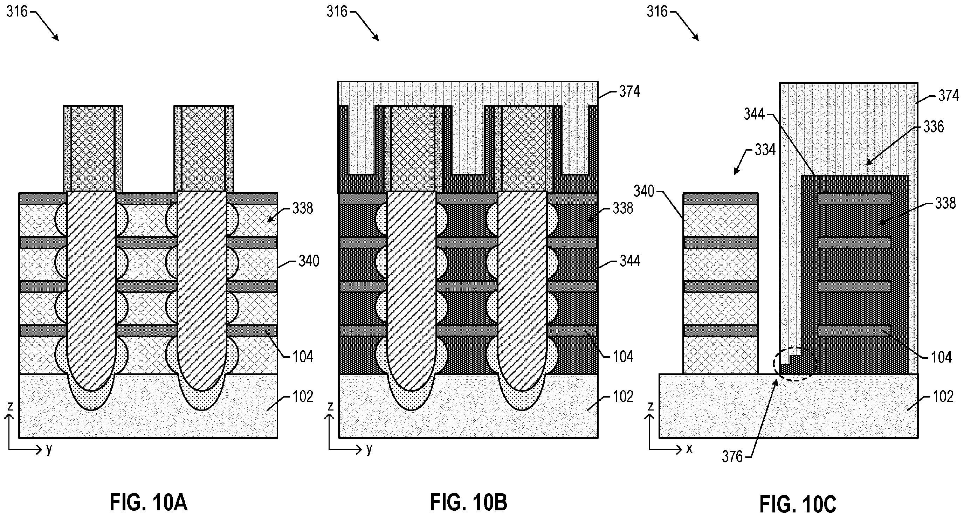

If the process 214 was performed one or more times, once all of the desired PWF material 344 is deposited, the method 200 may continue with a process 216 which is substantially the same as the process 210, where the PMOS portion of the IC structure is covered with a mask and the PWF material deposited in the last iteration of the process 214 is removed from the exposed NMOS portion. An IC structure 316 of FIG. 10 illustrates an example result of the process 216. As shown in FIG. 10, the IC structure 316 includes a mask 374 (similar to the mask 354) covering the PMOS stack 336, leaving the NMOS stack 334 exposed, which allows removing the PWF material 344 from the gate regions of the NMOS stack 334. This means that a layer of the PWF material 344 is removed from the sidewalls and bottoms of the openings between adjacent S/D contacts 340 of the NMOS stack 334, as shown in FIG. 10A. This also means that a layer of the PWF material 344 is removed from the sidewalls and top of the gate regions of the NMOS stack 334, as shown in FIG. 10C. Because the mask 374 cannot always be aligned perfectly with the location of the mask 354 used in the process 210, after the PWF material 344 is removed from areas not covered by the mask 374, a portion 376 of the PWF material 344 (shown in FIG. 10C in an area enclosed by a dashed contour) may remain at the bottom of all of the remaining PWF material 344, extending away from the PWF material 344 between the nanoribbons 104 of the PMOS stack 336. The portion 376 is similar to the portion 356, except that it includes the step profile of the portion 362 included therein.

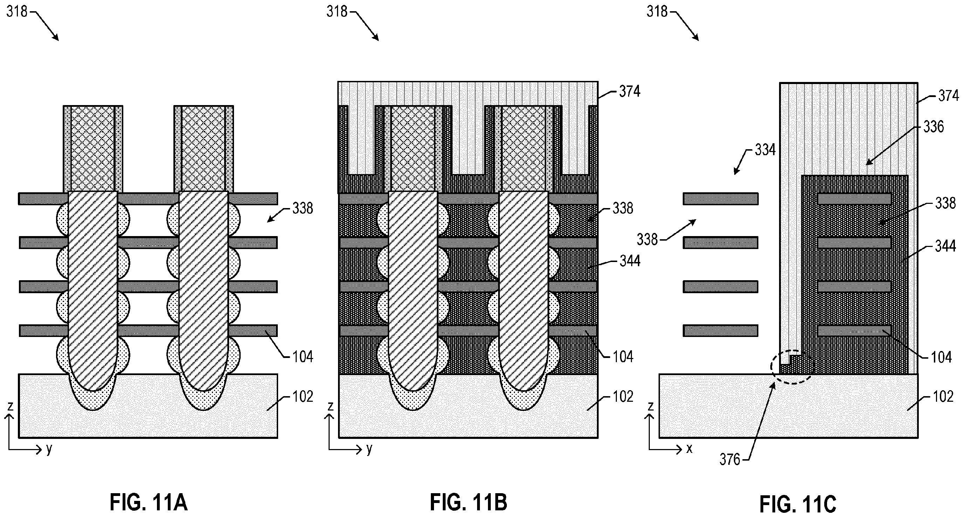

The method 200 may then proceed with a process 218, in which the PMOS portion of the IC structure is covered with a mask and the sacrificial material remaining in the NMOS portion is removed. An IC structure 318 of FIG. 11 illustrates an example result of the process 218. It should be noted that the process 218 may be performed after the process 216, or, if the processes 214 and 216 were not included, the process 218 may follow the process 212. As shown in FIG. 11, the IC structure 318 includes the mask 374 covering the PMOS stack 336 and leaving the NMOS stack 334 exposed, which allows removing the sacrificial material 340 from the gate regions of the NMOS stack 334. Removal of the sacrificial material 340 from the gate regions of the NMOS stack 334 may be performed similar to how it was done for removing the sacrificial material 340 from the gate regions of the PMOS stack 336 in the process 206. As a result of performing the process 218, the openings 338 between the nanoribbons 104 of the NMOS stack 334 are open again.

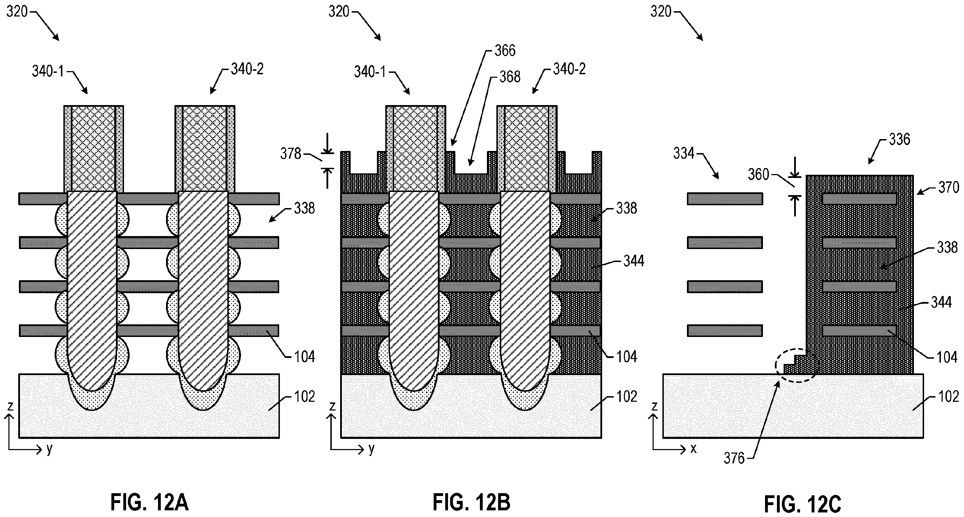

The method 200 may also include a process 220 which is substantially the same as the process 212, where the mask deposited over the PMOS portion of the IC structure is removed and the layer 346 of the PWF material deposited in the previous processes of the method 200 is recessed from the exposed PMOS portion. An IC structure 320 of FIG. 12 illustrates an example result of the process 220. As shown in FIG. 12B, the portions 366 on sidewalls of adjacent S/D contacts 340 of the PMOS stack 336 are recessed. In some embodiments, a height 378 of the portions 366 above the PMOS stack 336 may be similar to the analogous height 358, described above for the process 212. In some embodiments, the portions 366 may be removed completely, leaving only the portions 368 on top of uppermost the nanoribbon 104 of the PMOS stack 336. Any suitable process may be used in the process 220 to recess the portions 366 of the PWF material 344 in the PMOS stack 336, such as any suitable selective etch techniques.

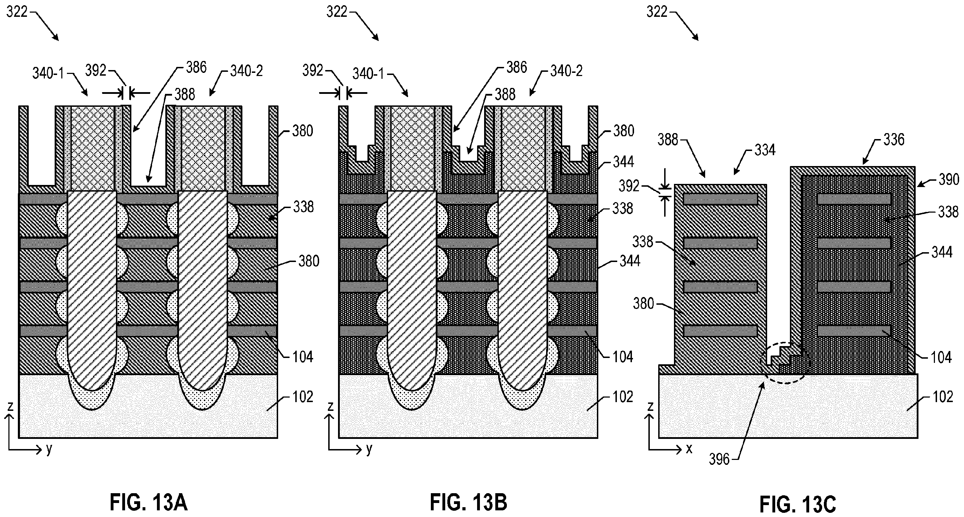

The method 200 may then proceed with a process 222, in which a layer of an NWF material may be deposited on all exposed surfaces. An IC structure 322 of FIG. 13 illustrates an example result of the process 222. As shown in FIG. 13, the IC structure 322 includes an NWF material 380 both in the gate regions of the NMOS stack 334 and the PMOS stack 336. Because the sacrificial material 340 was removed from the openings 338 between the nanoribbons 104 of the NMOS stack 334 in the process 218, the NWF material 380 may be deposited into those areas and may completely fill the openings 338 of the NMOS stack 334, or at least pinch off these openings. Because the PWF material 344 fills or pinches off the openings 338 between the nanoribbons 104 of the PMOS stack 336, no NWF material 380 is deposited there. Because the NWF material 380 is deposited after all rounds of deposition of the PWF material 344, no PWF material 344 will be present in the NMOS stack 334, leaving more space in the gate region of the NMOS stack 334 for a gate fill material closer to the nanoribbons 104 of the NMOS stack 334. This is advantageous compared to conventional NMOS-first fabrication methods because, as described above, having more of a gate fill material such as tungsten would be desirable for NMOS stacks in terms of metal gate strain imposed on the nanoribbons of the NMOS stacks.

FIGS. 13A and 13B specifically label a portion 386 of the NWF material 380 that is on sidewalls of the openings between adjacent S/D contacts 340. FIGS. 13A and 13B, as well as FIG. 13C, further specifically label a portion 388 of the NWF material 380 on top of the gate regions of the NMOS stack 334 and the PMOS stack 336 (i.e., the portion 388 is a portion of the NWF material 380 over the uppermost nanoribbons 104 of the stacks, substantially parallel to the support 102). FIG. 13C also specifically labels a portion 390 of the NWF material 380 on sidewalls of the gate regions of the NMOS stack 334 and the PMOS stack 336 (i.e., the portion 390 is a portion of the NWF material 380 that extends away from the support 102). The portions 386, 388, and 390 may be materially continuous portions of the NWF material 380, as depicted in FIG. 13. In some embodiments, a thickness 392 of each of the portions 386, 388, and 390 may be between about 0.5 nanometer and 20 nanometers, e.g., between about 0.5 and 10 nanometers, or between about 1 and 5 nanometers. FIG. 13C further illustrates a portion 396 (shown within a dashed contour) which includes the portion 376 of the PWF material 344, described above, with a layer of the NWF material 380 deposited thereon in the process 222. Examples of deposition techniques that may be used in the process 222 to deposit the NWF material 380 may include ALD or CVD, and the NWF material 380 may include any of the NWF materials described above, e.g., TiAIC.

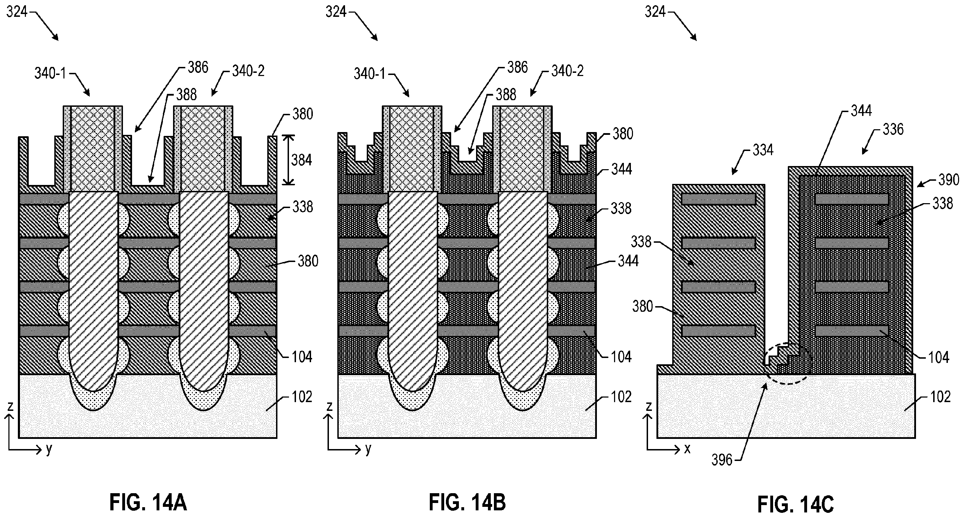

The method 200 may further include a process 224, in which the portion 386 of the NWF material deposited in the process 222 is recessed in both the NMOS and the PMOS portions. An IC structure 324 of FIG. 14 illustrates an example result of the process 224. As shown in FIG. 14A, the portion 386 of the NMOS stack 334 is recessed but some of that may still be remaining. For example, a height 384 of the portion 386 of the NWF material 380 in the NMOS stack 334 may be between about 1 nanometer and 20 nanometers, e.g., between about 3 and 20 nanometers, or between about 3 and 15 nanometers. As shown in FIG. 14B, some of the NWF material 380 may remain in the PMOS stack 336. However, in other embodiments, the process 224 may result in removal of all of the NWF material 380 from the PMOS stack 336. Any suitable process may be used in the process 224 to recess the NWF material 380, such as any suitable selective etch techniques. As a result of performing the process 224, openings may be formed between adjacent S/D contacts 340, both for the NMOS stack 334 and the PMOS stack 336.

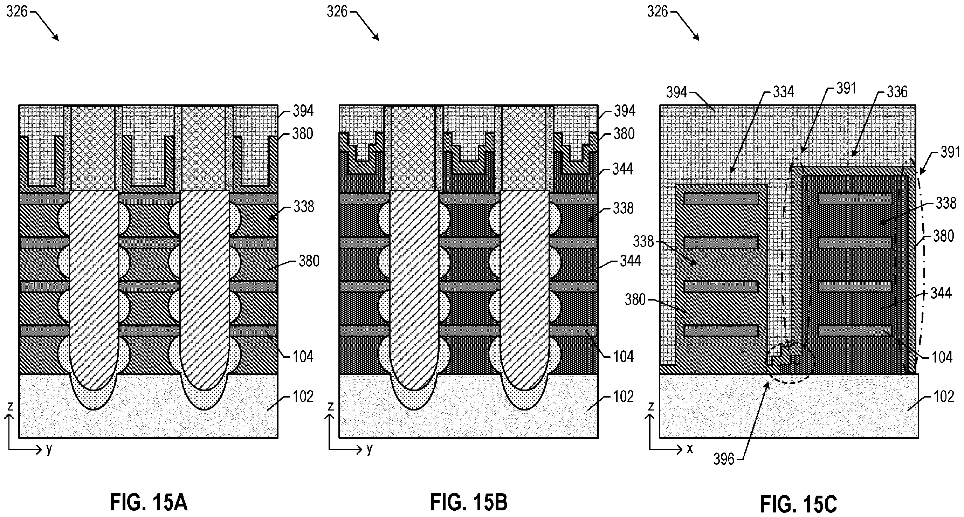

The method 200 may also include a process 226, in which a gate fill material is deposited over remaining exposed portions of the gate regions of the NMOS and PMOS stacks. An IC structure 326 of FIG. 15 illustrates an example result of the process 226. As shown in FIG. 15A and FIG. 15B, a gate fill material 394 may be deposited into openings at the top of the NMOS stack 334 and the PMOS stack 336 (i.e., between the sidewalls of adjacent S/D contacts 340). As shown in FIG. 15C, the gate fill material 394 may also be deposited on sidewalls of the NMOS stack 334 and the PMOS stack 336. Because the PWF material 344 fills or pinches off the openings 338 between the nanoribbons 104 of the PMOS stack 336, no gate fill material 394 is deposited there. This is in sharp contrast to conventional NMOS-first fabrication methods because, as described above, presence of some gate fill materials such as tungsten between adjacent nanoribbons of a PMOS stack is undesirable in terms of metal gate strain imposed on the nanoribbons of the PMOS stack. Examples of deposition techniques that may be used in the process 226 to deposit the gate fill material 394 may include ALD, CVD, PVD, etc., and the gate fill material 394 may include any suitable gate fill material such as tungsten.

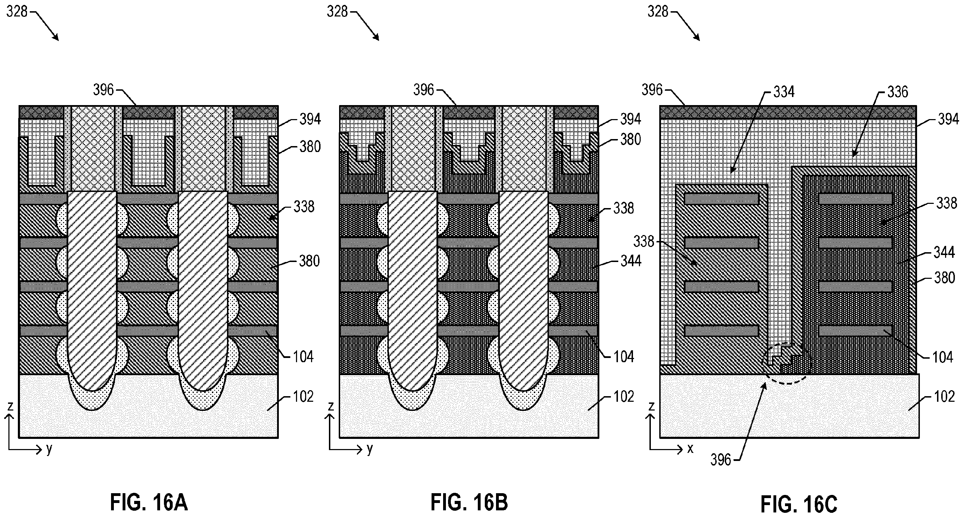

Optionally, the method 200 may also include a process 228, in which the gate fill material deposited in the process 226 is recessed and a gate contact material is provided. An IC structure 328 of FIG. 16 illustrates an example result of the process 228, where a gate contact material 396 is provided. Examples of deposition techniques that may be used in the process 228 to deposit the gate contact material 396 may include ALD, CVD, PVD, etc., and the gate contact material 396 may include any suitable electrically conductive material. The IC structure 328 is one example of the IC structure 100, described above. If the process 228 is not performed, then the IC structure 326 is one example of the IC structure 100, described above.

Performing the method 200 will result in several characteristic features in the IC structure 326 which would not be seen in IC structures with nanoribbon-based transistors that were not formed using the PMOS-first metal gate fabrication as described herein. For example, one such feature is the step profile as described above with reference to the portions 362, 376, and 396, which will be detectable in the final IC structure. Another such feature is presence of the NWF material 380 over the PWF material 344 on the sidewalls of the gate region of the PMOS stack 336, as is shown with regions 391 within dash-dotted contours shown in FIG. 15C, because in the method 200 the NWF material 380 is deposited after the PWF material 344. In other words, in the regions 391, the PWF material 344 is between the NWF material 380 and the nanoribbons 104 of the PMOS stack 336. Yet another feature characteristic of the use of the method 200 may be that the openings 338 of the gate regions of the NMOS stack 334 are filled only with the NWF material 380 but no PWF material 344, while the openings 338 of the gate regions of the PMOS stack 336 are filled only with the PWF material 344 but no NWF material 380. This is in sharp contrast to conventional NMOS-first metal gate fabrication, where, typically, both the NWF material and the PWF material are present in the openings between the nanoribbons of the NMOS stacks. Another feature characteristic of the use of the method 200 may be that the openings 338 of the gate regions of the PMOS stack 336 do not include any gate fill material 394. This is also in sharp contrast to conventional NMOS-first metal gate fabrication, where, typically, the gate fill material is present in the openings between the nanoribbons of the PMOS stacks.

Nanoribbon-based transistors fabricated using PMOS-first metal gate fabrication as described herein (e.g., as described with reference to FIGS. 1-3) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures 100 disclosed herein, e.g., the IC structures 100 implemented as the IC structures 326 or 328, may be included in any suitable electronic component. FIGS. 17-21 illustrate various examples of apparatuses that may include any of the IC structures 100 disclosed herein.

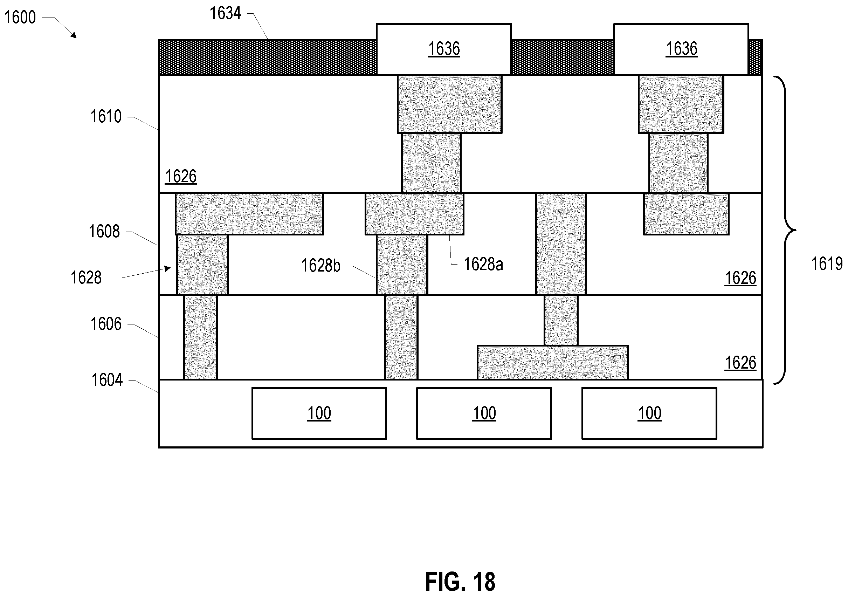

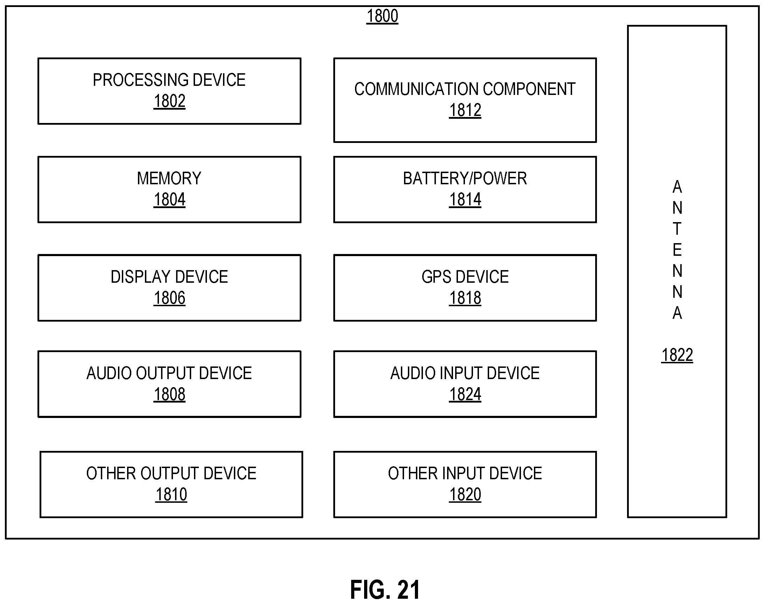

FIG. 17 is a top view of a wafer 1500 and dies 1502 that may include one or more IC structures 100 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100 (e.g., as discussed below with reference to FIG. 18), one or more transistors (e.g., some of the transistors of the device region 1604 of FIG. 18, discussed below, e.g., nanoribbon-based transistors of the IC structures 100) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 21) or other logic that is configured to store information in the memory devices or execute instructions stored in the memory array.

FIG. 18 is a side, cross-sectional view of an IC device 1600 that may include one or more IC structures 100 in accordance with any of the embodiments disclosed herein. One or more of the IC devices 1600 may be included in one or more dies 1502 (FIG. 17). The IC device 1600 may include a device region 1604 including one or more IC structures 100 disclosed herein, e.g., one or more of the IC structures 100 implemented as the IC structures 326 or 328. The device region 1604 may further include electrical contacts to the gates of the transistors included in the device region 1604 (e.g., to the gate fill material 394 of the IC structures 100) and to the S/D materials of the transistors included in the device region 1604 (e.g., to the S/D regions 114 of the IC structures 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 18 as interconnect layers 1606-1610). For example, electrically conductive features of the device region 1604 (e.g., the gate electrode material 108 of the IC structures 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 18). Although a particular number of interconnect layers 1606-1610 is depicted in FIG. 18, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 18. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 18. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structures 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 18, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

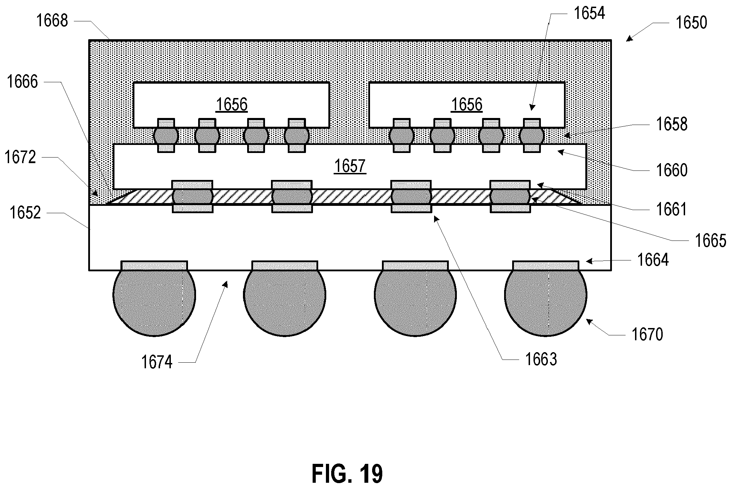

FIG. 19 is a side, cross-sectional view of an example IC package 1650 that may include one or more IC structures 100 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnects 1628 discussed above with reference to FIG. 18.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 19 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 19 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

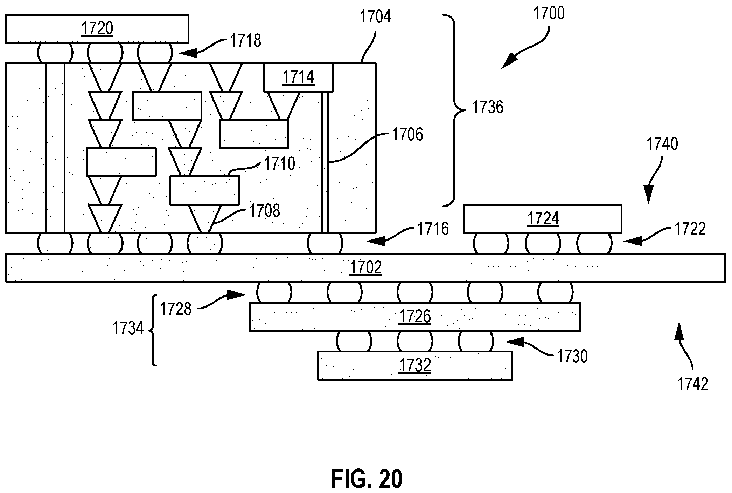

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 19 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 20.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 19 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 19, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 20 is a side, cross-sectional view of an IC device assembly 1700 that may include one or more IC packages or other electronic components (e.g., a die) including one or more IC structures 100 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 19 (e.g., may include one or more IC structures 100).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 20 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 20), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 20, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 17), an IC device (e.g., the IC device 1600 of FIG. 18), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 20, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 20 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 21 is a block diagram of an example electrical device 1800 that may include one or more IC structures 100 in accordance with any of the embodiments disclosed herein. For example, any suitable ones of the components of the electrical device 1800 may include one or more of the IC device assemblies 1700, IC packages 1650, IC structures 1600, or dies 1502 disclosed herein. A number of components are illustrated in FIG. 21 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 21, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure that includes a support (e.g., a substrate, a die, a wafer, or a chip, e.g., support 102 described herein); a first stack of two or more nanoribbons stacked vertically above one another above the support, where portions of the nanoribbons of the first stack are channel regions of N-type transistors (i.e., the first stack is an NMOS stack); a second stack of two or more nanoribbons stacked vertically above one another above the support, where portions of the nanoribbons of the second stack are channel regions of P-type transistors (i.e., the first stack is a PMOS stack); a first gate region enclosing portions of the nanoribbons of the first stack and including an NWF material between adjacent nanoribbons of the first stack; and a second gate region enclosing portions of the nanoribbons of the second stack and including a PWF material between adjacent nanoribbons of the second stack, where the second gate region includes the PWF material at sidewalls of the nanoribbons of the second stack and further includes the NWF material so that the PWF material is between the sidewalls of the nanoribbons of the second stack and the NWF material.

Example 2 provides the IC structure according to example 1, where the PWF material between the sidewalls of the nanoribbons of the second stack and the NWF material has one side in contact with the sidewalls of the nanoribbons of the second stack and has another side in contact with the NWF material.

Example 3 provides the IC structure according to examples 1 or 2, where, in the first gate region, the PWF material is absent between the adjacent nanoribbons of the first stack.

Example 4 provides the IC structure according to any one of the preceding examples, where, in the first gate region, the NWF material fills areas between the adjacent nanoribbons of the first stack.

Example 5 provides the IC structure according to example 4, where the first gate region further includes a gate dielectric material on the adjacent nanoribbons of the first stack, and where the NWF material fills areas between the gate dielectric material on the adjacent nanoribbons of the first stack.

Example 6 provides the IC structure according to any one of the preceding examples, where, in the second gate region, the PWF material fills areas between the adjacent nanoribbons of the second stack.

Example 7 provides the IC structure according to example 6, where the second gate region further includes a gate dielectric material on the adjacent nanoribbons of the second stack, and where the PWF material fills areas between the gate dielectric material on the adjacent nanoribbons of the second stack.

Example 8 provides the IC structure according to any one of the preceding examples, further including a gate fill material, the gate fill material including a first portion in the first gate region above an uppermost nanoribbon of the first stack, and a second portion in the second gate region above an uppermost nanoribbon of the second stack, where the gate fill material is absent between the adjacent nanoribbons of the second stack in the second gate region.

Example 9 provides the IC structure according to example 8, where the first portion and the second portion are materially continuous portions of the gate fill material in the first gate region and the second gate region.

Example 10 provides the IC structure according to examples 8 or 9, where, in the first gate region, sidewalls of the nanoribbons of the first stack are in contact with one side of the NWF material, and another side of the NWF material is in contact with the gate fill material.

Example 11 provides the IC structure according to any one of the preceding examples, where, in a cross-section of the second stack in the second gate region in a plane substantially perpendicular to a longitudinal axis of one of the nanoribbons of the second stack, a portion of the PWF material below a lowermost nanoribbon of the second stack has a step profile.

Example 12 provides the IC structure according to any one of the preceding examples, where, in a cross-section of the second stack in the second gate region in a plane substantially perpendicular to a longitudinal axis of one of the nanoribbons of the second stack, a first portion of the PWF material below a lowermost nanoribbon of the second stack has a first thickness and a second portion of the PWF material below the lowermost nanoribbon of the second stack has a second thickness that is different from the first thickness.

Example 13 provides an IC structure that includes a support (e.g., a substrate, a die, a wafer, or a chip, e.g., support 102 described herein); a first stack of two or more nanoribbons stacked vertically above one another above the support; a second stack of two or more nanoribbons stacked vertically above one another above the support; a first gate region enclosing portions of the nanoribbons of the first stack and including an NWF material between adjacent nanoribbons of the first stack; and a second gate region enclosing portions of the nanoribbons of the second stack and including a PWF material between adjacent nanoribbons of the second stack, where the PWF material is absent between the adjacent nanoribbons of the first stack in the first gate region.

Example 14 provides the IC structure according to example 13, where, in the first gate region, the NWF material fills areas between the adjacent nanoribbons of the first stack.

Example 15 provides the IC structure according to example 14, where the first gate region further includes a gate dielectric material on the adjacent nanoribbons of the first stack, and where the NWF material fills areas between the gate dielectric material on the adjacent nanoribbons of the first stack.

Example 16 provides the IC structure according to any one of examples 13-15, where, in the second gate region, the PWF material fills areas between the adjacent nanoribbons of the second stack.

Example 17 provides the IC structure according to any one of examples 13-16, where, in a cross-section of the second stack in the second gate region in a plane substantially perpendicular to a longitudinal axis of one of the nanoribbons of the second stack, a first portion of the PWF material below a lowermost nanoribbon of the second stack has a first thickness and a second portion of the PWF material below the lowermost nanoribbon of the second stack has a second thickness that is different from the first thickness.

Example 18 provides a method of fabricating an IC structure, the method including providing a first stack of nanoribbons and a second stack nanoribbons; depositing one or more layers of a PWF material to partially surround channel regions of the nanoribbons of the first stack and to fully surround channel regions of the nanoribbons of the second stack; removing all layers of the PWF material surrounding the channel regions of the nanoribbons of the first stack; and depositing an NWF material to surround the channel regions of the nanoribbons of the first stack after removing all layers of the PWF material surrounding the channel regions of the nanoribbons of the first stack.

Example 19 provides the method according to example 18, further including plugging areas between the channel regions of adjacent nanoribbons of the first stack with a sacrificial material prior to depositing the one or more layers of the PWF material to partially surround channel regions of the nanoribbons of the first stack.

Example 20 provides the method according to example 19, further including removing the sacrificial material prior to depositing the NWF material to surround the channel regions of the nanoribbons of the first stack.

Example 21 provides the method according to any one of examples 18-20, where the IC structure is an IC structure according to any one of the preceding examples.

Example 22 provides an IC package that includes an IC die including an IC structure according to any one of examples 1-17; and a further IC component, coupled to the IC die.

Example 23 provides the IC package according to example 22, where the further IC component includes a package substrate.

Example 24 provides the IC package according to example 22, where the further IC component includes an interposer.

Example 25 provides the IC package according to example 22, where the further IC component includes a further IC die.

Example 26 provides a computing device that includes a carrier substrate and an IC structure coupled to the carrier substrate, where the IC structure is an IC structure according to any one of examples 1-17, or the IC structure is included in the IC package according to any one of examples 22-25.

Example 27 provides the computing device according to example 26, where the computing device is a wearable or handheld computing device.

Example 28 provides the computing device according to examples 26 or 27, where the computing device further includes one or more communication chips.

Example 29 provides the computing device according to any one of examples 26-28, where the computing device further includes an antenna.

Example 30 provides the computing device according to any one of examples 26- 29, where the carrier substrate is a motherboard.

Example 31 provides the IC structure according to any one of examples 1-17, where the IC structure includes or is a part of a central processing unit.

Example 32 provides the IC structure according to any one of examples 1-31, where the IC structure includes or is a part of a memory device, e.g., a high-bandwidth memory device.

Example 33 provides the IC structure according to any one of examples 1-32, where the IC structure includes or is a part of a logic circuit.

Example 34 provides the IC structure according to any one of examples 1-33, where the IC structure includes or is a part of input/output circuitry.

Example 35 provides the IC structure according to any one of examples 1-34, where the IC structure includes or is a part of an FPGA transceiver.

Example 36 provides the IC structure according to any one of examples 1-35, where the IC structure includes or is a part of an FPGA logic.

Example 37 provides the IC structure according to any one of examples 1-36, where the IC structure includes or is a part of a power delivery circuitry.

Example 38 provides the IC structure according to any one of examples 1-37, where the IC structure includes or is a part of a III-V amplifier.

Example 39 provides the IC structure according to any one of examples 1-38, where the IC structure includes or is a part of PCIE circuitry or DDR transfer circuitry.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first stack of nanoribbons, wherein portions of the nanoribbons of the first stack are channel regions of N-type transistors;
a second stack of nanoribbons, wherein portions of the nanoribbons of the second stack are channel regions of P-type transistors;
a first gate region enclosing portions of the nanoribbons of the first stack and comprising an N-type work function (NWF) material between adjacent nanoribbons of the first stack; and
a second gate region enclosing portions of the nanoribbons of the second stack and comprising a P-type work function (PWF) material between adjacent nanoribbons of the second stack,
wherein the second gate region includes the PWF material at sidewalls of the nanoribbons of the second stack and further includes the NWF material so that the PWF material is between the sidewalls of the nanoribbons of the second stack and the NWF material.

2. The IC structure according to claim 1, wherein the PWF material between the sidewalls of the nanoribbons of the second stack and the NWF material has one side in contact with the sidewalls of the nanoribbons of the second stack and has another side in contact with the NWF material.

3. The IC structure according to claims 1 or 2, wherein, in the first gate region, the PWF material is absent between the adjacent nanoribbons of the first stack.

4. The IC structure according to any one of the preceding claims, wherein, in the first gate region, the NWF material fills areas between the adjacent nanoribbons of the first stack.

5. The IC structure according to claim 4, wherein the first gate region further includes a gate dielectric material on the adjacent nanoribbons of the first stack, and wherein the NWF material fills areas between the gate dielectric material on the adjacent nanoribbons of the first stack.

6. The IC structure according to any one of the preceding claims, wherein, in the second gate region, the PWF material fills areas between the adjacent nanoribbons of the second stack.

7. The IC structure according to claim 6, wherein the second gate region further includes a gate dielectric material on the adjacent nanoribbons of the second stack, and wherein the PWF material fills areas between the gate dielectric material on the adjacent nanoribbons of the second stack.

8. The IC structure according to any one of the preceding claims, further comprising a gate fill material, the gate fill material including:
a first portion in the first gate region above an uppermost nanoribbon of the first stack, and
a second portion in the second gate region above an uppermost nanoribbon of the second stack,
wherein the gate fill material is absent between the adjacent nanoribbons of the second stack in the second gate region.

9. The IC structure according to claim 8, wherein the first portion and the second portion are materially continuous portions of the gate fill material in the first gate region and the second gate region.

10. The IC structure according to claims 8 or 9, wherein, in the first gate region, sidewalls of the nanoribbons of the first stack are in contact with one side of the NWF material, and another side of the NWF material is in contact with the gate fill material.

11. The IC structure according to any one of the preceding claims, wherein, in a cross-section of the second stack in the second gate region in a plane substantially perpendicular to a longitudinal axis of one of the nanoribbons of the second stack, a portion of the PWF material below a lowermost nanoribbon of the second stack has a step profile.

12. The IC structure according to any one of the preceding claims, wherein, in a cross-section of the second stack in the second gate region in a plane substantially perpendicular to a longitudinal axis of one of the nanoribbons of the second stack, a first portion of the PWF material below a lowermost nanoribbon of the second stack has a first thickness and a second portion of the PWF material below the lowermost nanoribbon of the second stack has a second thickness that is different from the first thickness.

13. A method of fabricating an integrated circuit (IC) structure, the method comprising:
providing a first stack of nanoribbons and a second stack nanoribbons;
depositing one or more layers of a P-type work function (PWF) material to partially surround channel regions of the nanoribbons of the first stack and to surround channel regions of the nanoribbons of the second stack;
removing the PWF material surrounding the channel regions of the nanoribbons of the first stack; and
depositing an N-type work function (NWF) material to surround the channel regions of the nanoribbons of the first stack after removing the PWF material surrounding the channel regions of the nanoribbons of the first stack.

14. The method according to claim 13, further comprising:
plugging areas between the channel regions of adjacent nanoribbons of the first stack with a sacrificial material prior to depositing the one or more layers of the PWF material to partially surround channel regions of the nanoribbons of the first stack.

15. The method according to claim 14, further comprising:
removing the sacrificial material prior to depositing the NWF material to surround the channel regions of the nanoribbons of the first stack.
